# EUROPÄISCHE PATENTSCHRIFT

(11) **EP 0 951 580 B1**
(45) Veröffentlichungstag und Bekanntmachung des Hinweises auf die Patenterteilung: **04.04.2001**
(21) Anmeldenummer: 97948779.0
(22) Anmeldetag: 22.10.1997
(51) Int. Cl.: C23C 16/02, C23C 16/26

(54) **Verfahren zur Herstellung einer Beschichtung**
Method for producing a coating
Procédé de fabrication d'un revêtement

(30) Priorität: 28.10.1996 DE 19644692
(43) Veröffentlichungstag der Anmeldung: 27.10.1999
(73) Patentinhaber: ABB PATENT GmbH, 68309 Mannheim (DE)
(72) Erfinder: REISS, Harald, D-69118 Heidelberg (DE); WETZKO, Manfred, D-69259 Wilhelmsfeld (DE)
(74) Vertreter: Hellwig, Tillmann, Dr.
(86) Internationale Anmeldenummer: EP9705830
(87) Internationale Veröffentlichungsnummer: WO9818977

(56) Entgegenhaltungen:
- EP-A- 0 500 253
- EP-A- 0 625 588
- GB-A- 1 069 535
- PATENT ABSTRACTS OF JAPAN vol. 097, no. 004, 30.April 1997 & JP 08 337874 A (MATSUSHITA ELECTRIC IND CO LTD), 24.Dezember 1996,

## Beschreibung

Die Erfindung bezieht sich auf ein Verfahren zur Herstellung einer Beschichtung gemäß dem Oberbegriff der Patentansprüche 1 und 2.

Solche Beschichtungen sind beispielsweise für Bauelemente vorgesehen, deren Begrenzungsflächen in einen direkten Kontakt mit dampfförmigen Medien gebracht werden.

Rohrleitungen für Kühlmittel von Kondensatoren, die Bestandteil von Kraftwerken sind, werden bis jetzt teilweise oder vollflächig mit einem Flüssigkeitsfilm benetzt, wenn das für den Wärmetransport benutzte Arbeitsfluid an diesen Rohrleitungen durch Phasenübergang von seinem dampfförmigen in seinen flüssigen Zustand übergeführt wird.

Diese Flüssigkeitsfilme stellen wegen der vergleichsweise geringen Wärmeleitfähigkeit des Arbeitsfluids einen Wärmewiderstand dar, der etwa 30% des Gesamtwärmewiderstands ausmacht. Dieser setzt sich zusammen aus dem konvektiven Wärmewiderstand an der Grenzfläche zwischen Kühlmittel und den Innenflächen der Rohrleitungen des Kondensators, dem Wärmewiderstand des Rohrmaterials, dem Wärmewiderstand von eventuellen Ablagerungen auf den Rohrleitungen oder nicht kondensierbaren Dämpfen sowie dem Wärmewiderstand, der durch den oben erwähnten Phasenübergang an der äußeren Oberfläche der Rohrleitung erzeugt wird.

Durch einen solchen zusammenhängenden Flüssigkeitsfilm wird weiterhin der Strömungswiderstand erhöht, den das dampfförmige Arbeitsfluid beim Durchströmen der Zwischenräume zwischen den Rohrleitungen zu überwinden hat, da Reibungskräfte zwischen dem Dampf und dem Kondensat auftreten.

Eine solche Filmkondensation bringt nicht nur diese Nachteile mit sich, sondern sie kann auch zu Verunreinigungen und Ablagerungen auf den Bauelementen führen, wenn entsprechende Stoffe im Arbeitsfluid mitgeführt oder in ihm gelöst sind. Solche

Ablagerungen können ihrerseits wiederum den Wärmewiderstand an den Begrenzungsflächen der Rohrleitungen vergrößern.

In der EP-A-0500 253 ist ein Verfahren beschrieben, bei dem Oberflächen mit einem diamantähnlichen Kohlenstoff beschichtet werden. Um die Haftfestigkeit dieser Schicht zu verbessern, wird die Oberfläche eines Substrats, auf welche der Kohlenstoff aufgetragen wird, mit einer definierten Rauhigkeit versehen. Der Kohlenstoff wird an den rauhen Stellen verankert, wodurch die gesamte Schicht einen besseren Halt auf der Oberfläche erfährt.

Aus der GB-A-1069 535 ist ein Verfahren zur Verbesserung des Siedens bekannt. Bei der Anwendung des Verfahrens werden benetzbare und nicht benetzbare Bereiche ausgebildet. Die nichtbenetzbaren Bereiche der Oberfläche sollen eine Blasenbildung auslösen, indem sie Blasenkeime bevorraten. Im Gegensatz dazu sollen die benetzbaren Bereiche ein schnelles Blasenwachstum fördern.

In der EP-A-625 588 ist die Schichtzusammensetzung einer amorphen Kohlenstoffschicht beschrieben. Mit ihrer chemischen Zusammensetzung ist eine gezielte Steuerung der Benetzungseigenschaften bzw. Nichtbenetzungseigenschaften möglich. Ein verbessertes Haftvermögen der Schicht wird mit Hilfe von zusätzlichen Zwischen- und Gradientenschichten erreicht.

Der Erfindung liegt die Aufgabe zugrunde, ein Verfahren aufzeigen, mit dem die Ausbildung von Flüssigkeitsfilmen auf den Begrenzungsflächen von Bauelementen und die Bildung fester Ablagerungen vermieden werden können.

Diese Aufgabe wird, das Verfahren betreffend, durch die Merkmale der Patentansprüche 1 und 2 gelöst.

Mit Hilfe eines Überzugs aus nichtbenetzbarem amorphem Kohlenstoff auf den Begrenzungsflächen von Bauelementen, die mit dem Dampf und/oder dem Kondensat eines Mediums unmittelbar in Kontakt stehen, ist es möglich, die Ausbildung eines zusammenhängenden Kondensatfilms zu verhindern. Vor allem kann mit einem solchen Überzug erreicht werden, dass sich das für den Wärmetransport in Kraftwerken verwendete Arbeitsfluid im Kondensator auf den Oberflächen von Rohrleitungen, durch die ein Kühlmittel geleitet wird, nur in Form von Tropfen niederschlägt. Damit erhöht sich der Wärmedurchgangskoeffizient des Kondensators um ca. 5 bis 15 %. Da mit diesen Maßnahmen auch der Druckabfall des Arbeitsfluids beim Durchströmen der Zwischenräume zwischen den Rohrleitungen verringert wird, läßt sich das Vakuum des Kondensators um ca. 4 bis 8 hPa bei einem Kondensatorauslegedruck von ca. 50 hPa absenken.

Zur Verringerung des Wärmewiderstands zwischen dem Überzug aus nichtbenetzbarem amorphen Kohlenstoff und einem Bauelement wird dieses vor der Beschichtung mit amorphem Kohlenstoff soweit aufgerauht, dass die effektive Grenzfläche zwischen Bauelement und Beschichtung vergrößert wird. Die Vergrößerung hängt von der Struktur der Rauhigkeit und der Tiefe der Aufrauhung ab. Die zu beschichtenden Begrenzungsflächen des Bauelements werden vorzugsweise zwischen 0,1 und 2 µm tief aufgerauht. Das Aufrauhen erfolgt mittels chemischem oder physikalischem Ätzen. Vorzugsweise wird Plasmaätzen angewendet. Hiermit wird die effektive Grenzfläche um etwa einen Faktor 1,5 bis 2 vergrößert. Bei der anschließenden Beschichtung wird der Überzug so dick aufgetragen, daß eine geschlossene und glatte Oberfläche aus nichtbenetzbarem amorphen Kohlenstoff gebildet wird, auf welcher der Dampf kondensieren kann.

Eine weitere Verbesserung der Wärmeübertragung zwischen einem dampfförmigen Arbeitsfluid und einem mit nichtbenetzbarem amorphen Kohlenstoff beschichteten Bauelement kann dadurch erzielt werden, daß die zu beschichtenden Begrenzungsflächen bis zu einer Tiefe von 20µm mit einem der oben beschriebenen Verfahren aufgerauht werden. Anschließend wird der Überzug nur so dick aufgetragen, daß die Begrenzungsflächen mit dem nichtbenetzbaren amorphen Kohlenstoff überdeckt sind, jedoch keine glatten Oberflächen ausgebildet werden. Anschließend werden diese Oberflächen mechanisch geglättet. Dabei werden Oberflächen ausgebildet, die sowohl unbeschichtete Bereiche der Begrenzungsflächen sowie mit nichtbenetzbarem amorphen Kohlenstoff beschichtete Bereiche aufweisen. Die Größe der Gesamtfläche der unbeschichteten Bereiche beträgt nach dem Glätten weniger als 50% der Gesamtfläche der beschichteten Bereiche. Mit diesen Maßnahmen wird sichergestellt, daß das dampfförmige Arbeitsmedium weiterhin in Tropfenform an dem Bauelement kondensiert. Durch den direkten Kontakt zwischen dem dampfförmigem Arbeitsmedium und den unbeschichteten Begrenzungsflächen des Bauelements wird eine verbesserte Wärmeübertragung erreicht.

Bei Bauelementen, deren Begrenzungsflächen nicht mit dem erfindungsgemäßen Überzug versehen sind, werden Tropfen, die beim Kondensieren von dampfförmigen Medien entstehen, so auseinandergezogen, daß sie ineinander fließen und geschlossene Flüssigkeitsschichten bilden. Ein Maß für das Nichtbenetzen einer Fläche durch eine Flüssigkeit ist der Benetzungswinkel. Die erfindungsgemäße Beschichtung ist so ausgebildet, daß der stationäre Benetzungswinkel zwischen dem Überzug und der Flüssigkeit größer als 90 Grad ist. Dieses bedeutet, daß das dampfförmige Arbeitsfluid nur in Form von Tropfen auf den beschichteten Flächen kondensiert. Kondensate, die sich beispielsweise in einem Kraftwerkskondensator bilden, erzeugen deshalb keinen geschlossen Film auf Flächen, die mit einer nichtbenetzbaren organisch modifizierten Keramik beschichtet sind. Die Grenzflächenwechselwirkungen zwischen dem Überzug und dem Arbeitsfluid sind hierbei so klein, dass die Tropfen nicht oder nur geringfügig auf den Flächen haften. Unter der Einwirkung der Schwerkraft rinnen sie schließlich an den Flächen der Rohrleitungen herab. Dabei werden andere Tropfen mitgerissen und freie Bereiche auf den Oberflächen der Rohrleitungen gebildet, in denen wieder dampfförmiges Arbeitsfluid kondensieren kann. Durch das schnelle Herabrinnen der Tropfen wird die Verweilzeit des Arbeitsfluids auf den Rohrleitungen verringert und damit der Aufbau eines erhöhten Wärmewiderstands durch einen Kondensatfilm verhindert.

Überzüge aus nichtbenetzbarem amorphen Kohlenstoff werden dadurch hergestellt, daß bei der Abscheidung Fluor oder Silizium eingeleitet werden. Nichtbenetzbarer amorphem Kohlenstoff läßt sich gemäß folgender Strukturformel darstellen: a-C:H:X, wobei a für amorph und X für die chemischen Elemente Fluor oder Silizium steht. Nichtbenetzbarer amorpher Kohlenstoff weist eine niedrige Oberflächenenergie von ca. 20mJ/m² auf. Trotzdem verfügt er über eine Oberflächenhärte von etwa 1500 HV und damit über eine hohe Abriebfestigkeit. Flächen von Bauelementen, die einen Überzug aus nichtbenetzbarem amorphem Kohlenstoff aufweisen, bieten zudem den Vorteil, daß sich auf ihnen keine Ablagerungen bilden können, die beispielsweise durch kleine Partikel oder gelöste Stoffe hervorgerufen werden, welche von einem Arbeitsfluid mitgeführt werden. Oxidschichten können sich auf einem solchen Überzug ebenfalls nicht ausbilden.
- Fig. 1: Bauelemente mit der erfindungsgemäßen Beschichtung,
- Fig. 2: einen Ausschnitt aus einer beschichteten Begrenzungsfläche,
- Fig. 3: einen Ausschnitt aus einer teilweise fertiggestellten Begrenzungsfläche,
- Fig. 4: einen Ausschnitt aus einer weiteren Begrenzungsfläche.

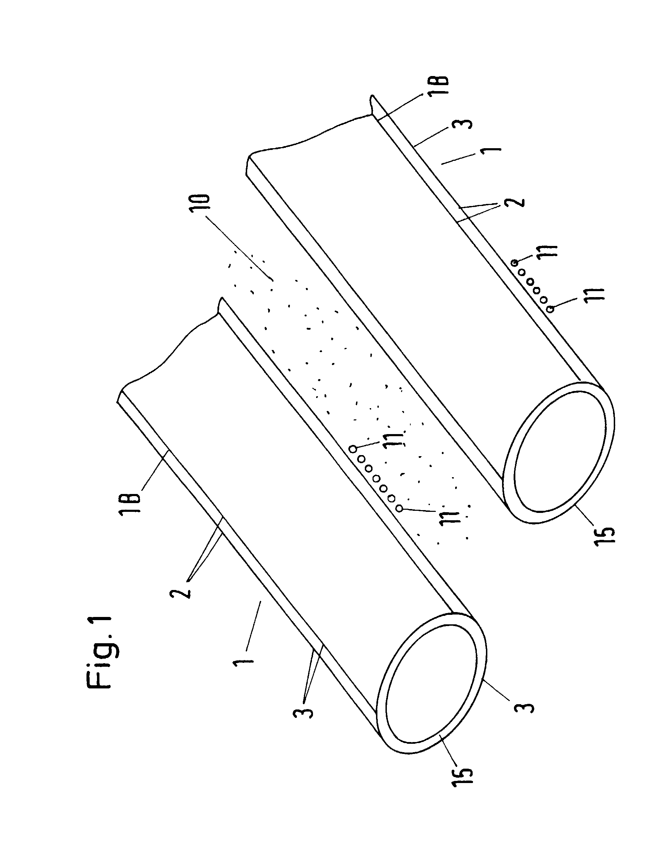

Die zur Beschreibung gehörige Fig. 1 zeigt zwei rohrförmige Bauelemente 1 aus Metall. Die Bauelemente 1 gehören zu einem Bündel von Rohrleitungen eines Kondensators, der Bestandteil eines Kraftwerks (hier nicht dargestellt) ist. Die beiden Bauelemente 1 sind aus Titan gefertigt und weisen jeweils eine Wandstärke von 0,5 bis 0,7mm auf. Sie sind mit einem Wandabstand von etwa 5mm bis 10mm voneinander angeordnet. Jedes der beiden Bauelemente 1 ist auf seiner Außenfläche 1S mit einer Beschichtung 2 versehen. Diese Beschichtung 2 wird bei dem hier beschriebenen Ausführungsbeispiel durch einen vollflächigen glatten Überzug 3 aus einem nichtbenetzbaren amorphem Kohlenstoff gebildet, der sich gemäß folgender Strukturformel darstellen läßt: a-C:H:X, wobei X für die chemischen Elemente Fluor oder Silizium steht.

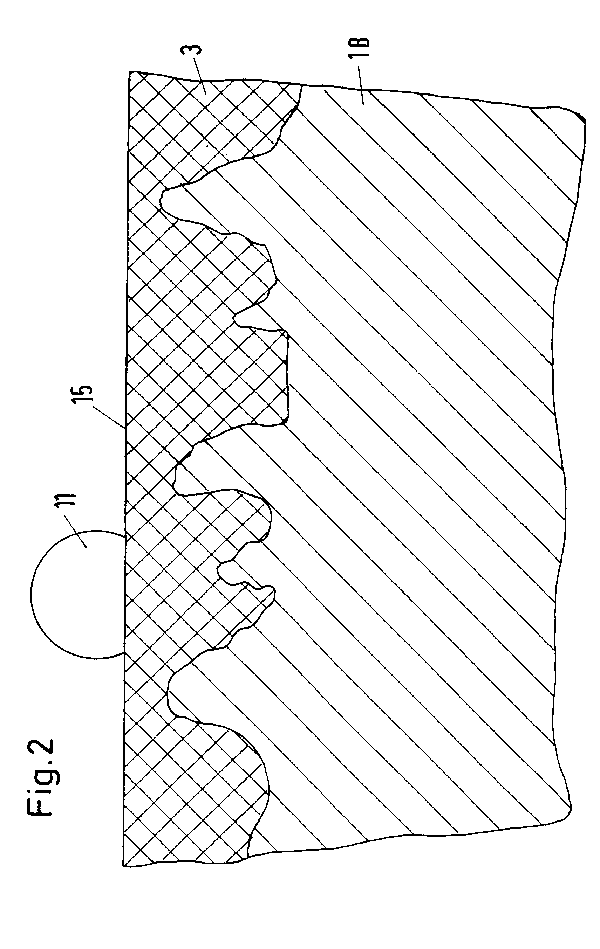

Zur Verringerung des Wärmewiderstands zwischen den Beschichtungen 2 und den Bauelementen 1 werden die Begrenzungsflächen 1B vor der Beschichtung aufgerauht, derart, daß die effektive Grenzfläche zwischen den Bauelementen 1 und den Beschichtungen 2 vergrößert wird. Diese Vergrößerung hängt von der Struktur der Rauhigkeit und der Tiefe der Aufrauhung ab. Die zu beschichtenden Begrenzungsflächen 1B werden vorzugsweise zwischen 0,1 und 2 µm tief aufgerauht. Das Aufrauhen erfolgt beispielsweise mittels chemischem oder physikalischem Ätzen. Bevorzugt erfolgt das Aufrauhen mittels Plasmaätzen. Hiermit wird die effektive Grenzfläche um etwa einen Faktor 1,5 bis 2 vergrößert. Bei dem anschließenden Beschichten der Begrenzungsflächen 1B wird der Überzug 3 mit einer Dicke von 3 bis 5 µm aufgetragen. Zum Auftragen des Überzugs 3 können chemische Abscheidungen aus der Gasphase oder physikalische Beschichtungstechniken verwendet werden. Vorzugsweise wird der Überzug 3 durch plasmaaktivierte Abscheidung oder Sputtern aufgetragen. In Fig. 2 ist der Teilbereich einer Begrenzungsfläche 1B vergrößert dargestellt. Wie Fig. 2 zu entnehmen ist, wird durch den Überzug 3 eine geschlossene und gleichzeitig glatte Oberfläche 1S aus nichtbenetzbarem amorphen Kohlenstoff gebildet. Wie die Fig. 1 und 2 zeigen, wird durch das Kondensat eines dampfförmigen Arbeitsfluid 10, das an die beschichteten Bauelemente 1 herangeführt wird und daran kondensiert, kein geschlossener Flüssigkeitsfilm erzeugt. Vielmehr bleibt das Kondensat an dem Überzug 3 nur in Form von Tropfen 11 kurzzeitig haften.

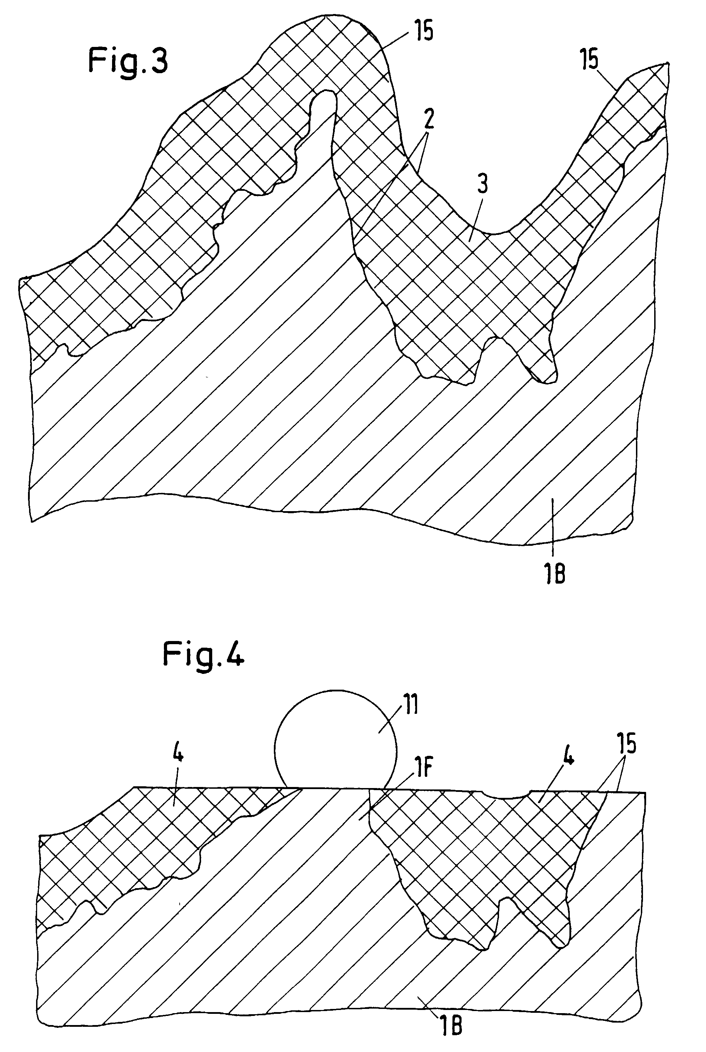

Eine weitere Verbesserung der Wärmeübertragung zwischen einem dampfförmigen Arbeitsfluid und einem mit nichtbenetzbarem amorphen Kohlenstoff beschichteten Bauelement kann dadurch erzielt werden, daß die zu beschichtenden Begrenzungsflächen bis zu einer Tiefe von 20µm mit einem der oben beschriebenen Verfahren aufgerauht werden. Wie Fig. 3 zeigt wird der Überzug 3 anschließend in Abhängigkeit von der Tiefe der Aufrauhung so dick aufgetragen, daß die Begrenzungsfläche 1B von dem nichtbenetzbaren amorphen Kohlenstoff gerade überdeckt ist, jedoch keine glatte Oberfläche 1S ausgebildet wird. Vorzugsweise wird der Überzug 3 bei einer Tiefe der Aufrauhung von 20µm bis zu 5µm dick aufgetragen. Anschließend wird die Oberfläche 1S mechanisch geglättet. Wie Fig. 4 zeigt, wird die Oberfläche 1S nach dem Glätten durch Bereiche 4 aus nichtbenetzbarem amorphen Kohlenstoff und durch freigelegte Bereiche 1F der Begrenzungsfläche 1B gebildet. Dadurch wird erreicht, daß das dampfförmige Arbeitsfluid (hier nicht dargestellt) bereichsweise unmittelbaren Kontakt mit nichtbeschichteten Bereichen 1F der Begrenzungsfläche 1B hat, wie es an Hand des Tropfens 11 in Fig. 4 veranschaulicht ist. Durch diesen direkten Kontakt wird eine verbesserte Wärmeübertragung zielt.

## Patentansprüche

1. Verfahren zur Herstellung einer Beschichtung von Bauelementen (1), deren Begrenzungsflächen (1B) mit dem Dampf und/oder dem Kondensat eines Mediums (10) in unmittelbaren Kontakt gebracht werden, dadurch gekennzeichnet, dass die Begrenzungsflächen (1B) bis zu 20 µm tief aufgerauht und darauf ein Überzug (3) in einer Dicke bis zu 5µm aus einem nichtbenetzbarem amorphem Kohlenstoff mit der Strukturformel: a-C:H:X, aufgetragen wird, wobei X für die chemischen Elemente Fluor oder Silizium steht, und dass die beschichteten Oberflächen (1S) anschließend so geglättet werden, dass die Gesamtfläche der unbeschichteten Bereiche (1F) kleiner als 50% der Gesamtfläche der mit nichtbenetzbarem amorphen Kohlenstoff beschichteten Bereiche (4) ist.

2. Verfahren zur Herstellung einer Beschichtung von Bauelementen (1), deren Begrenzungsflächen (1B) mit dem Dampf und/oder dem Kondensat eines Mediums (10) in unmittelbaren Kontakt gebracht werden, dadurch gekennzeichnet, dass die Begrenzungsflächen (1B) eines jeden Bauelements (1) bis zu einer Tiefe von 0,1µm bis 2µm aufgerauht werden, und dass darauf ein Überzug (3) in einer Dicke von 3µm bis 5µm aus einem nichtbenetzbarem amorphem Kohlenstoff mit der Strukturformel : a-C:H:X, aufgetragen wird, wobei X für die chemischen Elemente Fluor oder Silizium steht.

## Claims

1. Method for the manufacture of a coating of a component (1), the limiting surfaces (1B) of the component being put into immediate contact with the vapour end/or the condensate of a medium (10), **characterised in that** the limiting surfaces (1B) are roughened to a depth of up to 20 µm and that a coating (3) of a thickness of up to 5 µm of an amorphous and hydrophobic carbon with the structure formula a-C:H:X is put on the roughened surfaces, X representing the chemical elements fluorine or silicon, and that the coated surfaces (1S) are then so smoothened, that the overall surface of the non-coated regions (1F) is smaller than 50% of the overall surface of the regions (4) coated with hydrophobic amorphous carbon.

2. Method for the manufacture of a coating of a component (1), the limiting surfaces (1B) of the component being put into immediate contact with the vapour end/or the condensate of a medium (10), characterised in that the limiting surfaces (1B) of each component (1) are roughened to a depth of 0,1 µm to 2µm and that a coating (3) of a thickness of 3 µm to 5 µm of an amorphous and hydrophobic carbon with the structure formula a-C:H:X is put on the roughened surfaces, X representing the chemical elements fluorine or silicon.

## Revendications

1. Procédé pour la fabrication d'une couche d'un composant, dont les surfaces limitatives (1B) sont mises en contact direct avec la vapeur et/ou le condensât d'un milieu (10), **caractérisé en ce que** les surfaces limitatives (1B) sont rendues rugueuses jusqu'à une profondeur jusqu'à 20*µ*m et qu'un revêtement (3) avec une épaisseur jusqu'à 5*µ*m d'un carbone amorphe et non-mouillable avec la formule structurale a-C:H:X est mis sur les surfaces (1B), X représentant les éléments chimiques fluor ou silicium, et que les surfaces couvertes du revêtement (1S) sont lissées ensuite, tel que la surface totale des régions (1F) non couvertes d'un revêtement est inférieure à 50% de la surface totale des régions (4) couvertes du carbone amorphe et non-mouillable.

2. Procédé pour la fabrication d'une couche d'un composant, dont les surfaces limitatives (1B) sont mises en contact direct avec la vapeur et/ou le condensât d'un milieu (10), caractérisé en ce que les surfaces limitatives (1B) de chaque composant (1) sont rendues rugueuses jusqu'à une profondeur de 0,1µm à 2µm et qu'un revêtement (3) avec une épaisseur de 3µm à 5µm d'un carbone amorphe et non-mouillable avec la formule structurale a-C:H:X est mis sur les surfaces (1B), X représentant les éléments chimiques fluor ou silicium.
